(19) Europäisches Patentamt
European Patent Office
Office européen des brevets

(11) **EP 3 611 524 A1**

(12) **EUROPEAN PATENT APPLICATION**
published in accordance with Art. 153(4) EPC

(43) Date of publication:
**19.02.2020 Bulletin 2020/08**

(51) Int Cl.:
*G01R 31/36* (2020.01)   *H01M 10/42* (2006.01)
*H01M 10/48* (2006.01)   *H02J 7/00* (2006.01)

(21) Application number: **18784692.8**

(22) Date of filing: **20.03.2018**

(86) International application number:
**PCT/JP2018/010941**

(87) International publication number:
**WO 2018/190082 (18.10.2018 Gazette 2018/42)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **12.04.2017   JP 2017079199**

(71) Applicant: **Hitachi Chemical Company, Ltd.**
**Chiyoda-ku,**
**Tokyo 100-6606 (JP)**

(72) Inventors:
• **ASAKURA Ryoji**
  **Tokyo 100-8280 (JP)**
• **KAMIJOH Takashi**
  **Tokyo 100-6606 (JP)**
• **ONDA Hiroomi**
  **Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(54) **CELL SERVICE LIFE DIAGNOSTIC DEVICE AND CELL SERVICE LIFE DIAGNOSTIC METHOD**

(57)     There is provided a battery life diagnosis device includes: a storage unit configured to store a usage time of a battery measured at each time point and a measured value of a deterioration index indicating deterioration of the battery measured at each time; and a processing unit configured to diagnose a life of the battery. The processing unit obtains a time change amount of the deterioration index based on the usage time of the battery and the measured value of the deterioration index, obtains a prediction function of the deterioration index for each battery based on the time change amount of the deterioration index, obtains a predicted value of the deterioration index based on the prediction function of the deterioration index, and diagnoses the life of the battery based on the predicted value of the deterioration index.

[FIG. 1]

EP 3 611 524 A1

**Description**

Technical Field

The present invention relates to a battery life diagnosis device and a battery life diagnosis method.

Background Art

In a power supply for backup and a power storage system used for power stabilization, a battery serving as a component deteriorates as it is used. Therefore, the battery must be replaced at an appropriate time. In order to replace the battery at an appropriate time, it is necessary to diagnose a time at which the battery reaches a usage limit, that is, a life of the battery.
For example, PTL 1 describes a method for diagnosing when it is necessary to replace a battery. Specifically, a life is diagnosed based on a relationship between a measured value of an internal resistance obtained by measuring a battery to be subjected to life diagnosis for a plurality of times and an installation age that is a usage time of the battery at the time of measurement.

Prior Art Literature

Patent Literature

PTL 1: JP-A-2007-271438

Summary of Invention

Technical Problem

In a life diagnosis method disclosed in PTL 1, an internal resistance is used as a deterioration index indicating deterioration of the battery, and a battery life is diagnosed by predicting the internal resistance based on a usage time of the battery.
However, when transition of the internal resistance is compared between batteries, even if the usage times are the same, the transition of the internal resistance may be different depending on an individual difference for each battery or an installation environment such as a temperature. Therefore, in order to accurately diagnose the life of the battery, it is important to predict the internal resistance according to an individual state of the battery. PTL 1 does not refer to a method of predicting an internal resistance according to an individual state of a battery so as to diagnose a battery life.
An object of the invention is to diagnose a life of a battery according to an individual state of the battery.

Solution to Problem

A battery life diagnosis device according to an aspect of the invention includes: a storage unit configured to store a usage time of a battery measured at each time point and a measured value of a deterioration index indicating deterioration of the battery measured at each time point; and a processing unit configured to diagnose a life of the battery, in which the processing unit obtains a time change amount of the deterioration index based on the usage time of the battery and the measured value of the deterioration index, obtains a prediction function of the deterioration index for each battery based on the time change amount of the deterioration index, obtains a predicted value of the deterioration index based on the prediction function of the deterioration index, and diagnoses the life of the battery based on the predicted value of the deterioration index.
A battery life diagnosis method according to an aspect of the invention includes: storing a usage time of a battery measured at each time point and a measured value of a deterioration index indicating deterioration of the battery measured at each time point; obtaining a time change amount of the deterioration index based on the usage time of the battery and the measured value of the deterioration index; obtaining a prediction function of the deterioration index for each battery based on the time change amount of the deterioration index; obtaining a predicted value of the deterioration index based on the prediction function of the deterioration index; and diagnosing a life of the battery based on the predicted value of the deterioration index.

Advantageous Effect

According to the invention, a life of a battery can be diagnosed according to an individual state of the battery.

Brief Description of Drawings

[FIG. 1] FIG. 1 is a block diagram of a battery life diagnosis device according to an embodiment.

[FIG. 2] FIG. 2 is a diagram showing a battery information data table which is an example of a battery information storage area.

[FIG. 3] FIG. 3 is a diagram showing a prediction function data table which is an example of a prediction function storage area.

[FIG. 4] FIG. 4 is a diagram showing an operation history data table which is an example of an operation history storage area.

[FIG. 5] FIG. 5 is a diagram showing a predicted value data table which is an example of a predicted value storage area.

[FIG. 6] FIG. 6 is a flowchart showing life diagnosis processing for a power storage system.

[FIG. 7] FIG. 7 is a flowchart showing life diagnosis processing for a storage battery.

[FIG. 8] FIG. 8 is a diagram showing an example of a display screen of a life diagnosis result.

[FIG. 9] FIG. 9 is a diagram showing an example of a display screen of a life diagnosis result.

[FIG. 10] FIG. 10 is a diagram showing an example of time change amount calculation processing.

[FIG. 11] FIG. 11 is a diagram showing an example of time transition of an internal resistance.

Description of Embodiments

Hereinafter, an embodiment will be described with reference to the drawings.

A life diagnosis device according to an embodiment determines a state of a battery by using a time change amount of a deterioration index such as an internal resistance, and changes a function for predicting the deterioration index of the battery.

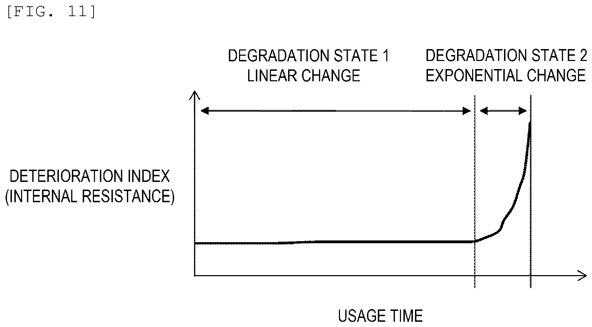

As shown in FIG.11, transition of the internal resistance changes from linear to exponential, for example. Therefore, future transition of the deterioration index of the battery can be predicted accurately by changing the prediction function of the deterioration index according to the state of the battery. As a result, a battery life can be diagnosed with high accuracy.

[Life Diagnosis Device]

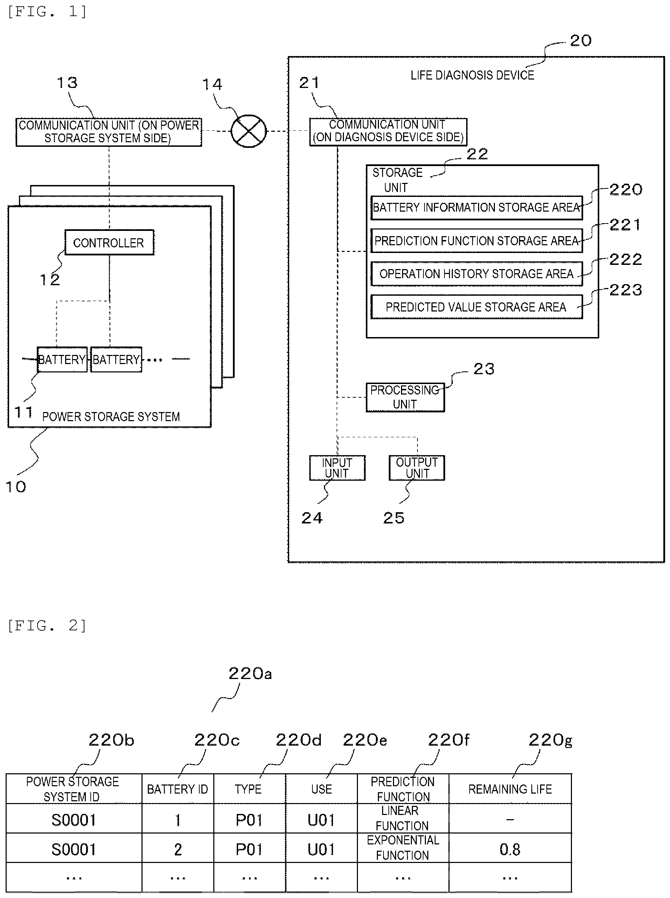

The life diagnosis device according to an embodiment will be described with reference to FIG. 1.

As shown in FIG. 1, a power storage system 10 includes one or more batteries 11 and a controller 12 connected to the battery 11. The controller 12 controls the power storage system 10 and the battery 11, and regularly collects measured values of the battery state such as an internal resistance, a voltage, a current, and a temperature as an operation history.

The collected operation history is regularly transmitted through a communication network 14 by a communication unit (on a power storage system side) 13 connected to the controller 12. There may be a plurality of power storage systems 10. In addition, the power storage system 10 may be structured as a power storage system in which, for example, a plurality of batteries 11 are bundled into a battery module so as to be easily managed. The power storage system 10 may be a storage system integrated with a communication unit by incorporating the communication unit (on a power storage system side) 13. The operation history may be a format to be collected and transmitted by the controller 12 in response to an instruction from the life diagnosis device 20.

The operation history is transmitted to the life diagnosis device 20 that functions as a monitoring device through the communication network 14. The life diagnosis device 20 is, for example, a server, and includes a communication unit (on a diagnosis device side) 21, a storage unit 22, a processing unit 23, an input unit 24, and an output unit 25. The server is not limited to a stand-alone type, and may be a cloud type.

As shown in FIG. 1, the transmitted operation history is regularly stored in the storage unit 22. The storage unit 22 includes a battery information storage area 220 for storing basic information of the storage battery system 10 and the battery 11 which are to be diagnosed, a prediction function storage area 221 for storing a prediction function used to predict an deterioration index such as an internal resistance, an operation history storage area 222 for storing an operation history, and a predicted value storage area 223 for storing a prediction result of the deterioration index. The storage unit 22 is connected to the communication unit (on a diagnosis device side) 21 and the processing unit 23 to exchange data.

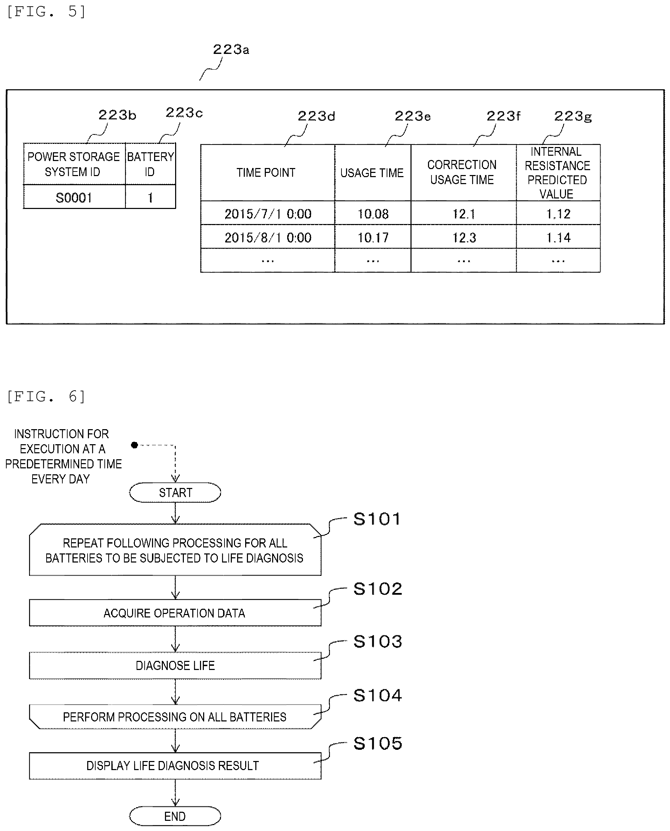

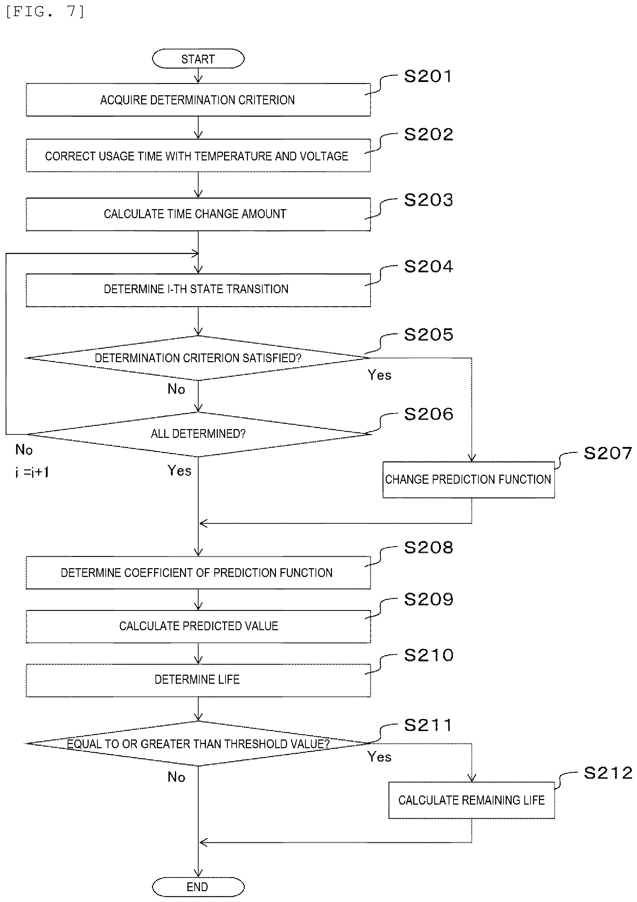

The processing unit 23 diagnoses a life of the battery 11 by executing a program on the basis of information stored in the storage unit 22. Life diagnosis processing will be described with reference to flowcharts shown in FIGS. 6 and 7, which will be described later.

The input unit 24 receives an information input by a user operation. The input unit 24 includes, for example, a mouse or a keyboard. The output unit 25 outputs information to a user. The output unit 25 includes, for example, a display or a printer. Further, an e-mail, a telephone, a FAX or the like may be used. A result of the life diagnosis processing of the processing unit 23 is transmitted to the user through the output unit 25.

[Storage Unit]

Next, examples of respective storage areas in the storage unit 22 are shown.

The battery information storage area 220 stores the basic information of the storage battery system 10 and the battery 11 which are to be diagnosed. FIG. 2 shows a battery information data table 220a which is an example of the battery information storage area 220. The table includes fields of a power storage system ID column 220b, a battery ID column 220c, a type column 220d, a use column 220e, a prediction function column 220f, and a remaining life column 220g.

The power storage system ID column 220b stores information for uniquely identifying a power storage system to be diagnosed. The battery ID column 220c stores information for uniquely identifying a battery to be diagnosed. In the information stored in the power storage system ID column 220b and the battery ID column 220c, information associated with fields of the same name in the operation history data table 222a and the predicted value data table 223a described later is stored.

The type column 220d stores information for specifying types (for example, lead, lithium ions) of the battery identified in the power storage system ID column 220b and the battery ID column 220c. The use column 220e stores information for specifying uses (for example, a backup use or a variation relaxation use) of the battery identified in the power storage system ID column 220b and the battery ID column 220c. In the information stored in the type column 220d and the use column 220e, information associated with fields of the same name in the prediction function data table 221a described later is stored.

The prediction function column 220f stores information for specifying a format of the function used for prediction of the deterioration index. The remaining life column 220g stores information for specifying a remaining usage time until an end of the life. Information is stored in advance in the power storage system ID column 220b, the battery ID column 220c, the type column 220d, and the use column 220e by a designer or a user at a stage before the life diagnosis processing described later is executed. Information is stored in the prediction function column 220f and the remaining life column 220g by the life diagnosis processing described later.

The battery information data table 220a may additionally includes information of a customer who owns the power storage system 10 and information of an installed place and the like.

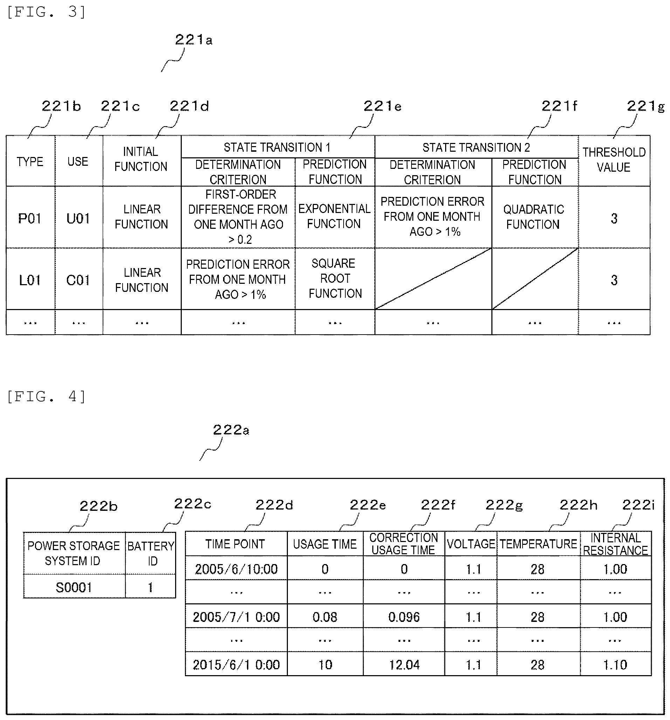

The prediction function storage area 221 stores information of the prediction function used to predict the deterioration index for each use or type of the battery. FIG. 3 shows a prediction function data table 221a which is an example of the prediction function storage area 221. The table includes fields of a type column 221b, a use column 221c, an initial function column 221d, a state transition 1 column 221e, a state transition 2 column 221f, and a threshold value column 221g.

The type column 221b stores information for specifying a type of the battery. The use column 221c stores information for specifying a use of the battery. The initial function column 221d stores information for specifying a function to be used to predict the deterioration index of a battery with the type and the use specified in the type column 221b and the use column 221c. The field is stored with information on the prediction function used when the battery 11 is in a state (an initial state) where determination criteria of the state transition 1 column 221e and the state transition 2 column 221f which will be described later are not satisfied.

The state transition 1 column 221e stores information for specifying a determination criterion that is a condition for changing a prediction function used to predict the deterioration index (determination criterion column in FIG. 3), and information for specifying a prediction function used in a case corresponding to the determination criterion (prediction function column in FIG. 3).

Similarly to the state transition 1 column 221e, the state transition 2 column 221f stores information for specifying a determination criterion that is a condition for changing a function used to predict the deterioration index (determination criterion column in FIG. 3) and information for specifying a prediction function used in a case corresponding to the determination criterion (prediction function column in FIG. 3). The threshold column 221g stores information for specifying a threshold value for determining a life based on the deterioration index.

An exponential function, a linear function, a quadratic function, and a square root function in FIG. 3 indicate that a prediction function having an exponential function term, a first-order term, a second-order term and a square root term is used with respect to the usage time of the battery 11. In the prediction function data table 221a, information is stored in advance by a designer or a user at a stage before the life diagnosis processing described later is executed. In this example, although a data table having two state transition columns is shown, a data table having three or more state transition columns may be configured.

The operation history storage area 222 stores information for specifying measurement data for each usage time of the power storage system 10 and the battery 11. FIG. 4 shows the operation history data table 222a, which is an example of the operation history storage area 222. The table includes fields of a power storage system ID column 222b, a battery ID column 222c, a time point column 222d, a usage time column 222e, a correction usage time column 222f, a voltage column 222g, a temperature column 222h, and an internal resistance column 222i.

The power storage system ID column 222b stores information for uniquely identifying the power storage system 10 whose information stored in the table has been measured. The battery ID column 220c stores information for uniquely identifying the battery 11 whose information stored in the table has been measured. The time point column 222d stores information for specifying a time point when the information stored in the table is measured.

The usage time column 222e stores information for specifying a usage time of the battery 11 when the information stored in the table is measured. The correction usage time column 222f stores a value obtained by correcting the usage time with a temperature or a voltage. The voltage column 222g stores a measured value of the voltage of the battery 11. The temperature column 222h stores a measured value of the temperature of the battery 11.

The internal resistance column 222i stores a calculated value of the internal resistance of the battery 11. In the present embodiment, the internal resistance is treated as a deterioration index. The internal resistance represents a phenomenon of voltage drop at the time of load connection with respect to an open circuit voltage as a resistance.

In addition to the above, the table may store measured values such as a current, a state of charge (SOC), and humidity.

A full charge capacitance may be used instead of the internal resistance as the deterioration index. The full charge capacitance is an electric quantity that can be released from a fully charged state to a fully discharged state of the battery. The table is prepared for each battery 11.

The predicted value storage area 223 stores information for specifying a predicted result of the deterioration index such as the internal resistance . FIG. 5 shows a predicted value data table 223a, which is an example of the predicted value storage area 223. The table includes fields of a power storage system ID column 223b, a battery ID column 223c, a time point column 223d, a usage time column 223e, a correction usage time column 223f, and an internal resistance predicted value column 223g.

The power storage system ID column 223b stores information for uniquely identifying the power storage system 10 whose predicted value is stored in the table. The battery ID column 223c stores information for uniquely identifying the battery 11 whose predicted value is stored in the table. The time point column 223d stores information for specifying a future time point. The usage time column 223e stores information for specifying a future usage time of the battery 11.

The correction usage time column 223f stores a value obtained by correcting a future usage time with a temperature or a voltage. The internal resistance predicted value column 223g stores a predicted value of the internal resistance (deterioration index) obtained based on the future time point and the usage time which are specified by the time point column 223d and the usage time column 223e. In the present embodiment, the predicted value of the internal resistance is used as the predicted value of the deterioration index, and a predicted value of the full charge capacitance may be used instead of the predicted value of the internal resistance. The table is prepared for each battery 11.

[Life Diagnosis Processing of Processing Unit 23]

Next, life diagnosis processing in the embodiment will be described.

In the life diagnosis processing, future transition of the internal resistance is predicted by using the information on the usage time and the internal resistance (deterioration index) stored in the operation history storage area 222, and the information on the prediction function stored in the prediction function storage area 221, and it is determined whether the internal resistance reaches a threshold value within a predetermined usage time. Alternatively, the time until the internal resistance reaches the threshold value is determined.

The life diagnosis processing executed by the processing unit 23 will be described with reference to flowcharts shown in FIGS. 6 and 7. The flowchart in FIG. 6 shows an overall life diagnosis processing, and the flowchart in FIG. 7 shows details of a part of the processing of the flowchart in FIG. 6.

First, the life diagnosis processing performed by the processing unit 23 will be described with reference to the flowchart in FIG. 6.

The processing unit 23 acquires operation data of the battery 10 (S102), performs processing of diagnosing a life diagnosis (S103) on all batteries to be subjected to life diagnosis (S101, S104), and displays a life diagnosis result (S105). Hereinafter, each processing will be described.

In processing of S101, the processing unit 23 starts a flow of the life diagnosis processing at a predetermined time every day. The processing unit 23 performs the following processing of S102 and S103 on all the batteries 10 to be subjected to life diagnosis. The battery 11 to be subjected to life diagnosis may be specified based on the power storage system ID and the battery ID which are stored in the battery data table 220a, or may be prepared based on a table for specifying the battery 11 to be subjected to life diagnosis separately.

In processing of S102, the processing unit 23 receives measured values such as the voltage, the temperature, and the internal resistance of the battery 11 from the power storage system 10, and stores the measured values in current time rows in the voltage column 222g and the temperature column 222h of the operation history data table 222a. The internal resistance may be measured based on Ohm's law by dividing a fluctuation amount of the voltage by a fluctuation amount of the current according to the following Equation 1.

```
Internal Resistance (t) = (Voltage (t) - Voltage

(t - Δt)/(Current (t) - Current (t - Δt)) ...(Equation 1)
```

Here, t is a certain time point, and Δt is a measurement interval of a battery state. The voltage (t) shows the battery voltage at t, and the current (t) shows the current flowing through the battery at t.

When the full charge capacitance is used as the deterioration index, the full charge capacitance is measured by extracting two time points when the battery is fully charged and when the battery is fully discharged, and integrating a current value between the two time points, and is stored in the data table.

Each measurement value may be stored as it is, or may be stored as a relative value obtained after being divided by a certain reference value (initial value or optimum value in design). Further, the processing unit 23 calculates a usage time that is a time period from the start of use of the battery 10, and stores the usage time in the current time row in the usage time column 222e. A value in the processing of S103 described later is stored in the correction usage time column 222f.

In the embodiment, although the processing unit 23 acquires data from the storage system 10 at a predetermined time, the storage system 10 may calculate a measured value at any time and store the measured value in the operation history data table 222a.

In processing of S103, the processing unit 23 uses the information stored in the operation history data table 222a to diagnose the life of the battery 10. In the processing, the prediction function, the remaining life, and the predicted value of the deterioration index (internal resistance) displayed in processing of S105 are calculated. That is, the prediction function column 220f and the remaining life column 220g of the battery information data table 220a, and the internal resistance predicted value column 223g of the predicted value data table 223a are stored with information. Details of the processing will be described later with reference to the flowchart in FIG. 7.

In processing of S104, after the processing unit 23 performs the processing of S102 and S103 on all the batteries 10 to be diagnosed, the processing proceeds to the following S105.

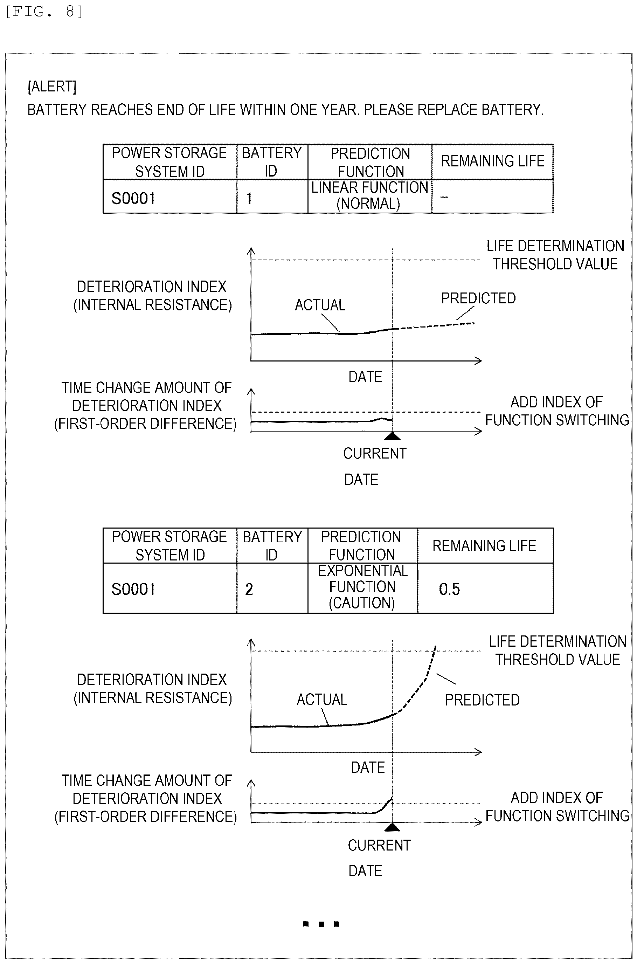

In processing of S105, the processing unit 23 displays the life diagnosis result on the output unit 25. FIG. 8 shows an example of a display screen displayed on the output unit 25. Hereinafter, an example of the display screen will be described with reference to FIG. 8.

The processing unit 23 displays information stored in the power storage system ID column 220b, the battery ID column 220c, the prediction function column 220f, and the remaining life column 220g of the battery information data table 220a on the output unit 25.

In addition, the information of the operation history data table 222a and the predicted value data table 223a corresponding to the power storage system ID and the battery ID are displayed as a graph. Specifically, the processing unit 23 displays a graph in which the information stored in the time point column 222d of the operation history data table 222a is on a horizontal axis and the information stored in the internal resistance column 222i is on a vertical axis. Further, superimposed on the graph, the information stored in the time point column 223d and the internal resistance predicted value column 223g of the predicted value data table 223a is displayed as a graph.

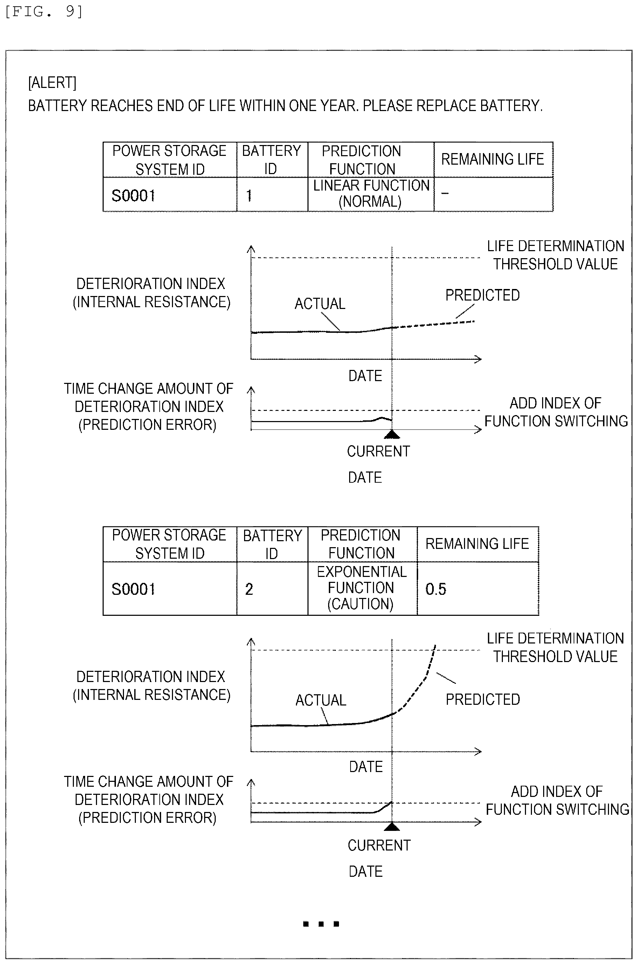

The processing unit 23 also displays transition of a time change amount used to determine the state transition. FIG. 8 shows an example in which a time change amount (first-order difference) to be described later is used to determine the state transition. As shown in FIG. 8, the time change amount (first-order difference) at each time point is displayed as a graph. The graph also displays a function switching threshold value of the determination criterion of the state transition. Accordingly, a user can grasp a timing at which the function switching is performed. When another value such as a time change amount (prediction error) to be described later is used to determine the state transition, the processing unit 23 displays a used time change amount as shown in FIG. 9.

Although arranged in an order of the power storage system ID and the battery ID, the information may be displayed in order from information of the battery 11 having a short remaining life. Further, the prediction function may be displayed in order from the information of the battery 11 with the exponential function. An instruction indicating an order to display information may be received from the user via the input unit 24 and the information is re-displayed in that order.

When there is a battery 11 whose remaining life falls within a predetermined period, the processing unit 23 displays, as an alert, that there is the battery 11 reaching an end of life.

Next, details of the processing of S103 in FIG. 6 will be described with reference to the flowchart in FIG. 7.

The processing unit 23 acquires the determination criterion of the state transition (S201), corrects the usage time with the temperature and the voltage (S202), and then calculates the time change amount of the internal resistance (deterioration index) used to determine the state transition (S203). The state transition is determined by using the calculated time change amount (S204 and S205). When the determination criterion is satisfied, the prediction function used to predict the internal resistance is changed (S207). When the determination criterion is not satisfied, the processing proceeds to determination of next state transition (S206).

Further, a coefficient of the prediction function is determined by using the operation history (S208), and the transition of the predicted value for the internal resistance (deterioration index) is calculated using the prediction function and the coefficient (S209). A life determination is performed by using the transition of the predicted value (S210 and S211) . When the internal resistance exceeds the threshold value in a predetermined period, the remaining life that is a remaining period until the threshold value is exceeded is calculated (S212), and the processing is ended.

Hereinafter, each processing will be described. In these processing, for the operation history data table 222a and the predicted value data table 223a, data of a table corresponding to the ID of the storage system 10 and the battery 11 which are to be subjected to life diagnosis is used.

In S201, the processing unit 23 acquires the information stored in the type column 220d and the use column 220e of the battery information data table 220a for the battery 11 to be subjected to life diagnosis. Hereinafter, the acquired information is referred to as the battery type and the battery use. The corresponding row of the type column 221b and the use column 221c of the prediction function data table 221a is specified using the battery type and the battery use. In the following processing, the information stored in the corresponding row of the prediction function data table 221a is used.

When the prediction function column 220f of the battery information data table 220a is blank, that is, when the life diagnosis is performed for the first time for the battery, the processing unit 23 stores information of the function stored in the initial function column 221d of the prediction function data table 221a.

In S202, the processing unit 23 calculates the correction usage time by using values of the usage time, the voltage, and the temperature, and stores the correction usage time in the operation history data table 222a. Specifically, the processing unit 23 calculates an average value of the voltages in all the rows and an average value of the temperatures in all the rows, and calculates the correction usage time by the following Equation (2).

$$\text{Correction Usage Time }(t) = \text{Usage Time }(t) \times$$
$$f\{2^{(\text{Temperature Average } - \text{ Temperature Reference Value})/u}\} \times g\{(\text{Voltage Average/Voltage Reference Value})^v\} \ ...(\text{Equation 2})$$

Here, t is a certain time point, and corresponds to each row of the operation history data table 222a. The usage time (t) indicates a usage time at a certain time point. The voltage average indicates the average value of the voltage, and the temperature average indicates the average value of the temperature. The temperature reference value, the voltage reference value, u, and v are predetermined positive coefficients.

The function f(x) is a function that returns 1 when the temperature average is smaller than the temperature reference value and returns x in other cases. The function g(x) is a function that returns 1 when the voltage average is smaller than the voltage reference value and returns x in other cases.

The return values of the functions f(x) and g(x) are greater than 1. Therefore, when a temperature average value is larger than a temperature reference value or when a voltage average value is larger than a voltage reference value, the correction usage time is larger than the actual usage time. When the value of temperature or voltage is large, an increasing rate of the internal resistance in a fixed time becomes large. However, by calculating the increasing rate of the internal resistance in the correction usage time using the correction usage time, contribution of the temperature and the voltage to the increase in the internal resistance can be reduced, and the increase in the internal resistance due to the temperature and the voltage can be separated from the increase in the internal resistance due to the state transition of battery 11. In the embodiment, although the temperature and the voltage are averaged in all the rows, an average value of every, for example, 10 rows may be calculated to calculate the correction usage time.

In S203, the processing unit 23 calculates a time change amount by using the correction usage time and the internal resistance. Specifically, the time change amount of the first-order difference is calculated by the following Equation (3) .

$$\text{Time Change Amount (First-order Difference)} =$$

$$\text{(Internal Resistance (t1)} - \text{Internal Resistance (t1} - \Delta t))/\text{(Correction Usage Time (t1)} - \text{Correction Usage Time (t1} - \Delta t)) \ldots \text{(Equation 3)}$$

Here, t1 is a time point at which the life diagnosis is performed, and corresponds to a last row of the operation history data table 222a (when each row is arranged in an order of the time point). $\Delta t$ is a time interval for taking a predetermined difference, for example, one month. The internal resistance (t1) and the internal resistance (t1 - $\Delta t$) indicate a value of the internal resistance at the time point, and the correction usage time (t1) and the correction usage time (t1 - $\Delta t$) indicate a value of the correction usage time at the time point.

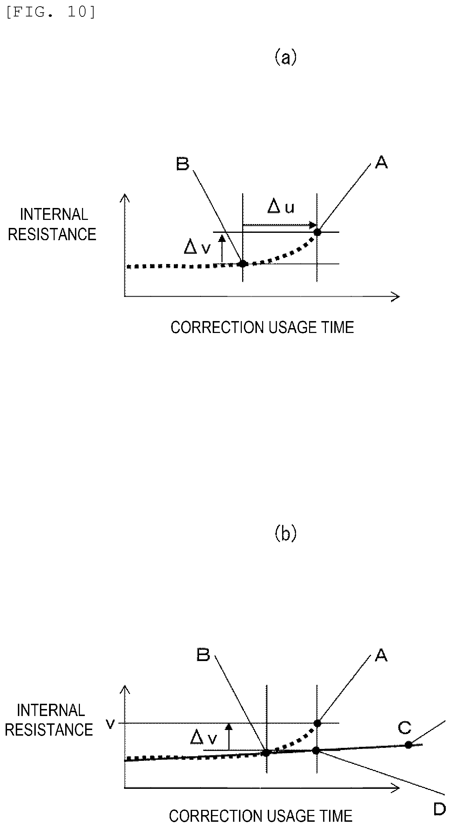

FIG. 10(a) is a diagram showing a calculation equation in a case of calculating the time change amount (first-order difference) according to Equation (3). As shown in the figure, in a curve in which the correction usage time and the internal resistance are plotted, the time change amount (first-order difference) can be calculated by taking a difference between the time point t1 and the time point t1 - $\Delta t$. The time change amount of the internal resistance which is the deterioration index can be calculated by using Equation (3). Here, A indicates the correction usage time and the internal resistance at the time point t1. B indicates the correction usage time and the internal resistance at the time point t1 - $\Delta t$. The time change amount (first-order difference) is $\Delta u/\Delta v$.

As another method of the time change amount, for example, a linear prediction equation of the correction usage time and the internal resistance (Example: internal resistance = a $\times$ correction usage time + b) may be created by using data of the correction usage time and the internal resistance from a measurement start to a certain predetermined time as a time point when the life diagnosis is performed, and the prediction error (prediction error = (measured value - predicted value), which is a ratio of the difference between the predicted value and the measured value of the internal resistance at the time point of life diagnosis according to this equation may be calculated and used as the time change amount.

FIG. 10(b) is a diagram showing a calculation equation in a case of using the prediction error. As shown in the figure, a linear prediction equation is created with a least-square method by using data of the correction usage time and the internal resistance up to the time point t1 - $\Delta t$, and the prediction error is calculated by using the difference between the predicted value and the measured value at the time point t1 of the linear prediction equation. Here, A indicates the correction usage time and the internal resistance at the time point t1. B indicates the correction usage time and the internal resistance at the time point t1 - $\Delta t$. C indicates the linear prediction equation created by applying the least-square method to the correction usage time and the internal resistance from the measurement start to the time point t1 - $\Delta t$. D indicates the predicted value of the internal resistance calculated by substituting the correction usage time at the time point t1 into the linear prediction equation. The time change amount (prediction error) is $\Delta v/v$.

In S204, the processing unit 23 determines the state transition by using the time change amount of the internal resistance. Specifically, the processing unit 23 compares the determination criterion in the state transition 1 column 221e stored in the row specified by the battery type and the battery use of the prediction function data table 221a with the time change amount, and determines whether the determination criterion is satisfied.

As shown in a conditional branch (S205), when the determination criterion is satisfied, the processing proceeds to prediction function changing processing (S207). As shown in the conditional branch (S205) and a conditional branch (S206), when the determination criterion is not satisfied, it is determined whether the determination criterion is satisfied with respect to the determination criterion in the state transition 2 column 221f, which is the determination criterion for the next state transition. Such processing is repeatedly executed until any one of the determination criteria is satisfied or all the state transition columns are determined.

In S207, the processing unit 23 acquires information stored in the prediction function column for the column of the state transition determined to satisfy the determination criterion in the conditional branch (S205), and stores the information in the row of the battery to be subjected to life diagnosis in the prediction function column 220f of the battery information data table 220a.

By the processing, the prediction function used to predict the internal resistance is changed in accordance with the state of the battery 11. For example, when the battery 11 is in a state where the internal resistance thereof is greatly increased, the state can be determined by the time change amount, and the prediction function can be changed to the exponential function.

In S208, the processing unit 23 determines a coefficient for the prediction function stored in the row of the battery to be subjected to life diagnosis in the prediction function column 220f of the battery information data table 220a.

For example, when the prediction function is specified as the linear function, the following Equation (4) is used.

When the prediction function is specified as the quadratic function, the following Equation (5) is used. When the prediction function is specified as the square root function, the following Equation (6) is used. When the prediction function is specified as the exponential function, the following Equation (7) is used. When the prediction function is specified as the exponential function, the following Equation (8) may also be used.

$$\text{Internal Resistance Predicted Value } (t) = a \times \text{Correction Usage Time } (t) + b \quad ...(\text{Equation } 4)$$

$$\text{Internal Resistance Predicted Value } (t) = a \times \text{Correction Usage Time } (t)^2 + b \times \text{Correction Usage Time } (t) + c \quad ...(\text{Equation } 5)$$

$$\text{Internal Resistance Predicted Value } (t) = a \times \text{Correction Usage Time } (t)^{0.5} + b \quad ...(\text{Equation } 6)$$

$$\text{Internal Resistance Predicted Value } (t) = a \times \exp(b \times \text{Correction Usage Time } (t)) + c \quad ...(\text{Equation } 7)$$

$$\text{Internal Resistance Predicted Value } (t) = a \times \exp(b \times \text{Correction Usage Time } (t)^2 + c \times \text{Correction Usage Time}(t)) + d \quad ...(\text{Equation } 8)$$

Here, t is a certain time point, and corresponds to each row of the operation history data table 222a. The correction usage time (t) indicates the correction usage time at a certain time, and the internal resistance predicted value (t) indicates the predicted value of the internal resistance column at a certain time. a, b, c, and d are coefficients determined by the processing unit 23.

For these equations, by using the values stored in the internal resistance column 222i and the correction usage time column 222f of the operation history data table 222a, each coefficient is determined with the least-square method so that a sum of squares of a residual between the value stored in the internal resistance column 222i and the internal resistance predicted value is minimized.

In S209, the predicted value of the internal resistance is calculated by using the prediction function determined in the processing of S208. Specifically, the processing unit 23 creates data from a time point of life diagnosis to a predetermined time for the time point column 223d and the usage time column 223e of the predicted value data table 223a. For example, the processing unit 23 creates data of the time point and the usage time every month in a period from the time point of life diagnosis to one year later.

Further, similarly to the processing of S202, the value of the correction usage time column 223f is calculated based on the value of the usage time column 223e by using the Equation (2) and stored in each row. Further, the internal resistance predicted value is calculated by using the prediction function determined in S208 and the value in the correction usage time column 223f, and is stored in each row of the internal resistance predicted value column 223g.

Accordingly, the predicted value of the future transition of the internal resistance of the battery 11 can be calculated.

In S210, the processing unit 23 determines whether the internal resistance predicted value calculated in the processing of S209 exceeds the threshold value. Specifically, the processing unit 23 acquires the threshold value stored in a row corresponding to the battery type and the battery use among the threshold values 221g of the prediction function data table 221a, and determines whether there is a row in which the predicted value exceeds the threshold value in the internal resistance predicted value column 223g of the predicted value data table 223a.

When the predicted value exceeds the threshold value, the processing proceeds to S212 as shown in a next conditional branch (S211). When there is no row in which the predicted value exceeds the threshold value, the processing is ended. When the full charge capacitance is used as the deterioration index, a case where the predicted value is below the threshold value may be used as a criterion for determination.

In S212, when the predicted value exceeds the threshold value, the processing unit 23 calculates and stores the remaining life. Specifically, the processing unit 23 acquires the value of the usage time column 223e in the row in which the predicted value exceeds the threshold value for the first time in the predicted value data table 221a, takes the difference between the usage time at the time of life diagnosis (the value of the last row of the usage time column 222e of the operation history data table 222a) to calculate the remaining life, and stores the remaining life in the rows of the battery system 10 and the battery 11 subjected to life diagnosis in the remaining life column 220g of the battery information data table 220a.

In this way, by the processing of the flowchart shown in FIG. 7, the prediction function remaining life and the predicted value of the deterioration index (internal resistance) can be calculated.

As described above, by using the life diagnosis processing executed by the life diagnosis device 20 according to the embodiment, the state of the battery 11 is determined by the time change amount of the internal resistance which is the deterioration index, so that the prediction function of the internal resistance can be switched according to the state of the battery 11, and the internal resistance can be accurately predicted. Accordingly, the life of the battery 11 determined by the internal resistance can also be accurately predicted.

Reference Sign List

10 ... power storage system, 11 ... battery, 20 ... life diagnosis device, 22 ... storage unit, 220 ... battery information storage area, 221 ... prediction function storage area, 222 ... operation history storage area, 223 ... predicted value storage area, 23 ... processing unit, 24 ... input unit, 25 ... output unit

**Claims**

1. A battery life diagnosis device, comprising:

   a storage unit configured to store a usage time of a battery measured at each time point and a measured value of a deterioration index indicating deterioration of the battery measured at each time point; and
   a processing unit configured to diagnose a life of the battery, wherein
   the processing unit is configured to

   obtain a time change amount of the deterioration index based on the usage time of the battery and the measured value of the deterioration index,
   obtain a prediction function of the deterioration index for each battery based on the time change amount of the deterioration index,
   obtain a predicted value of the deterioration index based on the prediction function of the deterioration index, and
   diagnose the life of the battery based on the predicted value of the deterioration index.

2. The battery life diagnosis device according to claim 1, wherein
   the processing unit is configured to

   compare the time change amount of the deterioration index with a predetermined threshold value for changing the prediction function so as to change the prediction function of the deterioration index,
   obtain a predicted value of the deterioration index based on the changed prediction function of the deterioration index, and
   compare the predicted value with a predetermined threshold value for determining the life so as to obtain a remaining life of the battery.

3. The battery life diagnosis device according to claim 1, wherein
   the processing unit includes:

   an operation history data table that stores a measured value of a temperature of the battery or a measured value of a voltage applied to the battery, which are measured at each time point, and

the processing unit is configured to
obtain a time change amount of the deterioration index by using a correction usage time which is obtained by correcting the usage time with the measured value of the temperature or the measured value of the voltage.

4. The battery life diagnosis device according to claim 1, wherein
the processing unit uses an internal resistance of the battery as the deterioration index.

5. The battery life diagnosis device according to claim 2, wherein
the storage unit includes:
a prediction function data table that stores the prediction function of the deterioration index and the threshold value for determining the life for each type or use of the battery.

6. The battery life diagnosis device according to claim 1, further comprising:
an output unit configured to display the measured value of the deterioration index of the battery and the predicted value of the deterioration index of the battery in a time series on a graph.

7. A battery life diagnosis method, comprising:

storing a usage time of a battery measured at each time point and a measured value of a deterioration index indicating deterioration of the battery measured at each time point in the storage unit;
by the processing unit, obtaining a time change amount of the deterioration index based on the usage time of the battery and the measured value of the deterioration index, obtaining a prediction function of the deterioration index for each battery based on the time change amount of the deterioration index, obtaining a predicted value of the deterioration index based on the prediction function of the deterioration index, and diagnosing a life of the battery based on the predicted value of the deterioration index.

8. The battery life diagnosis method according to claim 7, further comprising:

displaying the measured value of the deterioration index of the battery and the predicted value of the deterioration index of the battery in a time series on an output unit as a graph; and
displaying that there is a battery reaching a remaining life on the output unit as an alert when determining that the remaining life of the battery reaches within a predetermined period.

9. The battery life diagnosis method according to claim 8, further comprising:
displaying the time change amount of the deterioration index in a time series on the output unit as a graph.

[FIG. 1]

[FIG. 2]

| POWER STORAGE SYSTEM ID | BATTERY ID | TYPE | USE | PREDICTION FUNCTION | REMAINING LIFE |
|---|---|---|---|---|---|
| S0001 | 1 | P01 | U01 | LINEAR FUNCTION | – |
| S0001 | 2 | P01 | U01 | EXPONENTIAL FUNCTION | 0.8 |
| ... | ... | ... | ... | ... | ... |

[FIG. 3]

221a

| | | | STATE TRANSITION 1 | | STATE TRANSITION 2 | | |
| TYPE | USE | INITIAL FUNCTION | DETERMINATION CRITERION | PREDICTION FUNCTION | DETERMINATION CRITERION | PREDICTION FUNCTION | THRESHOLD VALUE |
|------|-----|-----------------|------------------------|--------------------|------------------------|--------------------|-----------------|
| P01 | U01 | LINEAR FUNCTION | FIRST-ORDER DIFFERENCE FROM ONE MONTH AGO > 0.2 | EXPONENTIAL FUNCTION | PREDICTION ERROR FROM ONE MONTH AGO > 1% | QUADRATIC FUNCTION | 3 |
| L01 | C01 | LINEAR FUNCTION | PREDICTION ERROR FROM ONE MONTH AGO > 1% | SQUARE ROOT FUNCTION | | | 3 |
| ... | ... | ... | ... | ... | ... | ... | ... |

221b 221c 221d 221e 221f 221g

[FIG. 4]

222a

| POWER STORAGE SYSTEM ID | BATTERY ID | TIME POINT | USAGE TIME | CORRECTION USAGE TIME | VOLTAGE | TEMPERATURE | INTERNAL RESISTANCE |
|------------------------|-----------|-----------|-----------|----------------------|---------|-------------|---------------------|
| S0001 | 1 | 2005/6/1 0:00 | 0 | 0 | 1.1 | 28 | 1.00 |
| | | ... | ... | ... | ... | ... | ... |
| | | 2005/7/1 0:00 | 0.08 | 0.096 | 1.1 | 28 | 1.00 |
| | | ... | ... | ... | ... | ... | ... |
| | | 2015/6/1 0:00 | 10 | 12.04 | 1.1 | 28 | 1.10 |

222b 222c 222d 222e 222f 222g 222h 222i

[FIG. 5]

223a

| POWER STORAGE SYSTEM ID | BATTERY ID | | TIME POINT | USAGE TIME | CORRECTION USAGE TIME | INTERNAL RESISTANCE PREDICTED VALUE |
|---|---|---|---|---|---|---|
| S0001 | 1 | | 2015/7/1 0:00 | 10.08 | 12.1 | 1.12 |
| | | | 2015/8/1 0:00 | 10.17 | 12.3 | 1.14 |
| | | | ... | ... | ... | ... |

223b 223c 223d 223e 223f 223g

[FIG. 6]

INSTRUCTION FOR
EXECUTION AT A
PREDETERMINED TIME
EVERY DAY

START

REPEAT FOLLOWING PROCESSING FOR ALL BATTERIES TO BE SUBJECTED TO LIFE DIAGNOSIS — S101

ACQUIRE OPERATION DATA — S102

DIAGNOSE LIFE — S103

PERFORM PROCESSING ON ALL BATTERIES — S104

DISPLAY LIFE DIAGNOSIS RESULT — S105

END

14

[FIG. 7]

```
                    ( START )
                        │
                        ▼
    ┌───────────────────────────────────────────┐      S201
    │     ACQUIRE DETERMINATION CRITERION        │
    └───────────────────────────────────────────┘
                        │
                        ▼
    ┌───────────────────────────────────────────┐      S202
    │  CORRECT USAGE TIME WITH TEMPERATURE AND   │
    │                 VOLTAGE                     │
    └───────────────────────────────────────────┘
                        │
                        ▼
    ┌───────────────────────────────────────────┐      S203
    │        CALCULATE TIME CHANGE AMOUNT        │
    └───────────────────────────────────────────┘
                        │
                        ▼
    ┌───────────────────────────────────────────┐      S204
    │       DETERMINE I-TH STATE TRANSITION      │
    └───────────────────────────────────────────┘
                        │
                        ▼
            DETERMINATION CRITERION SATISFIED?          S205
                   No  │            Yes
                        ▼
                 ALL DETERMINED?                        S206
      No                │            Yes
    i = i+1             │                    ┌──────────────────────────┐   S207
                        │                    │ CHANGE PREDICTION FUNCTION│
                        │                    └──────────────────────────┘
                        ▼
    ┌───────────────────────────────────────────┐      S208
    │   DETERMINE COEFFICIENT OF PREDICTION      │
    │                FUNCTION                     │
    └───────────────────────────────────────────┘
                        │
                        ▼
    ┌───────────────────────────────────────────┐      S209
    │         CALCULATE PREDICTED VALUE          │
    └───────────────────────────────────────────┘
                        │
                        ▼
    ┌───────────────────────────────────────────┐      S210
    │              DETERMINE LIFE                 │
    └───────────────────────────────────────────┘
                        │
                        ▼
        EQUAL TO OR GREATER THAN THRESHOLD VALUE?       S211
                   No  │            Yes
                        │                    ┌──────────────────────────┐   S212
                        │                    │  CALCULATE REMAINING LIFE │
                        │                    └──────────────────────────┘
                        ▼
                    ( END )
```

[FIG. 8]

[ALERT]
BATTERY REACHES END OF LIFE WITHIN ONE YEAR. PLEASE REPLACE BATTERY.

| POWER STORAGE SYSTEM ID | BATTERY ID | PREDICTION FUNCTION | REMAINING LIFE |
|---|---|---|---|
| S0001 | 1 | LINEAR FUNCTION (NORMAL) | – |

DETERIORATION INDEX (INTERNAL RESISTANCE)

LIFE DETERMINATION THRESHOLD VALUE

ACTUAL    PREDICTED

DATE

TIME CHANGE AMOUNT OF DETERIORATION INDEX (FIRST-ORDER DIFFERENCE)

ADD INDEX OF FUNCTION SWITCHING

CURRENT DATE

| POWER STORAGE SYSTEM ID | BATTERY ID | PREDICTION FUNCTION | REMAINING LIFE |
|---|---|---|---|
| S0001 | 2 | EXPONENTIAL FUNCTION (CAUTION) | 0.5 |

DETERIORATION INDEX (INTERNAL RESISTANCE)

LIFE DETERMINATION THRESHOLD VALUE

ACTUAL    PREDICTED

DATE

TIME CHANGE AMOUNT OF DETERIORATION INDEX (FIRST-ORDER DIFFERENCE)

ADD INDEX OF FUNCTION SWITCHING

CURRENT DATE

■ ■ ■

16

[FIG. 9]

[ALERT]
BATTERY REACHES END OF LIFE WITHIN ONE YEAR. PLEASE REPLACE BATTERY.

| POWER STORAGE SYSTEM ID | BATTERY ID | PREDICTION FUNCTION | REMAINING LIFE |
|---|---|---|---|
| S0001 | 1 | LINEAR FUNCTION (NORMAL) | – |

DETERIORATION INDEX (INTERNAL RESISTANCE)

ACTUAL

PREDICTED

LIFE DETERMINATION THRESHOLD VALUE

DATE

TIME CHANGE AMOUNT OF DETERIORATION INDEX (PREDICTION ERROR)

ADD INDEX OF FUNCTION SWITCHING

CURRENT DATE

| POWER STORAGE SYSTEM ID | BATTERY ID | PREDICTION FUNCTION | REMAINING LIFE |
|---|---|---|---|
| S0001 | 2 | EXPONENTIAL FUNCTION (CAUTION) | 0.5 |

DETERIORATION INDEX (INTERNAL RESISTANCE)

ACTUAL

PREDICTED

LIFE DETERMINATION THRESHOLD VALUE

DATE

TIME CHANGE AMOUNT OF DETERIORATION INDEX (PREDICTION ERROR)

ADD INDEX OF FUNCTION SWITCHING

CURRENT DATE

■ ■ ■

[FIG. 10]

(a)

INTERNAL RESISTANCE

CORRECTION USAGE TIME

(b)

INTERNAL RESISTANCE

CORRECTION USAGE TIME

[FIG. 11]

DEGRADATION STATE 1
LINEAR CHANGE

DEGRADATION STATE 2
EXPONENTIAL CHANGE

DETERIORATION INDEX
(INTERNAL RESISTANCE)

USAGE TIME

## INTERNATIONAL SEARCH REPORT

| International application No. |
| --- |
| PCT/JP2018/010941 |

**A. CLASSIFICATION OF SUBJECT MATTER**
Int.Cl.   G01R31/36(2006.01)i, H01M10/42(2006.01)i, H01M10/48(2006.01)i, H02J7/00(2006.01)i

According to International Patent Classification (IPC) or to both national classification and IPC

**B. FIELDS SEARCHED**

Minimum documentation searched (classification system followed by classification symbols)
Int.Cl. G01R31/36, H01M10/42, H01M10/48, H02J7/00

Documentation searched other than minimum documentation to the extent that such documents are included in the fields searched
| | |
| --- | --- |
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 2016-167336 A (THE CHUGOKU ELECTRIC POWER CO., INC.) 15 September 2016, paragraphs [0021]-[0038], [0070], [0099], fig. 1 (Family: none) | 1, 4, 7<br>6, 8-9<br>2-3, 5 |
| X<br>A | JP 2002-343444 A (FURUKAWA BATTERY CO., LTD.) 29 November 2002, paragraphs [0012]-[0021], fig. 1 (Family: none) | 1, 4, 7<br>2-3, 5-6, 8-9 |
| X<br>A | JP 2007-271438 A (FURUKAWA BATTERY CO., LTD.) 18 October 2007, paragraphs [0016]-[0031], fig. 1 (Family: none) | 1, 4, 7<br>2-3, 5-6, 8-9 |

☒ Further documents are listed in the continuation of Box C.     ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
| Date of the actual completion of the international search<br>    22 May 2018 (22.05.2018) | Date of mailing of the international search report<br>    05 June 2018 (05.06.2018) |
| Name and mailing address of the ISA/<br>    Japan Patent Office<br>    3-4-3, Kasumigaseki, Chiyoda-ku,<br>    Tokyo 100-8915, Japan | Authorized officer<br><br>Telephone No. |

Form PCT/ISA/210 (second sheet) (January 2015)

**EP 3 611 524 A1**

**INTERNATIONAL SEARCH REPORT**

International application No.

PCT/JP2018/010941

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2008-76295 A (OMRON CORP.) 03 April 2008, paragraphs [0049]-[0051] & CN 101149422 A | 6, 8-9 |
| P, X | JP 2017-212049 A (DENSO CORP.) 30 November 2017, paragraphs [0058]-[0061] (Family: none) | 1, 4, 7 |
| A | WO 2015/037184 A1 (GS YUASA INTERNATIONAL LTD.) 19 March 2015, entire text, all drawings & US 2016/0223617 A1 | 1-9 |
| A | JP 2010-139260 A (HITACHI, LTD.) 24 June 2010, entire text, all drawings & US 2010/0145644 A1 & EP 2196813 A2 | 1-9 |
| A | JP 2006-153663 A (SANYO ELECTRIC CO., LTD.) 15 June 2006, entire text, all drawings & US 2006/0113959 A1 | 1-9 |
| A | JP 2012-37337 A (MITSUBISHI HEAVY INDUSTRIES, LTD.) 23 February 2012, entire text, all drawings & WO 2012/018028 A1 & CN 103080762 A | 1-9 |
| A | US 2016/0299197 A1 (HYUNDAI MOROR COMPANY) 13 October 2016, entire text, all drawings & KR 2016/0120476 A & CN 106054079 A | 1-9 |
| A | US 2015/0301121 A1 (SUMSUNG ELECTRONICS CO., LTD.) 22 October 2015, entire text, all drawings & KR 2015/0121526 A | 1-9 |

Form PCT/ISA/210 (continuation of second sheet) (January 2015)

21

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007271438 A